Europäisches Patentamt

European Patent Office

Office européen des brevets

(11) Publication number: **0 207 874 B1**

# EUROPEAN PATENT SPECIFICATION

(45) Date of publication of patent specification: **27.12.91**   (51) Int. Cl.⁵: **C23C 30/00, B32B 15/01**

(21) Application number: **86630082.5**

(22) Date of filing: **06.05.86**

(54) **Substrate tailored coatings for superalloys.**

(30) Priority: **09.05.85 US 733001**

(43) Date of publication of application:
**07.01.87 Bulletin 87/02**

(45) Publication of the grant of the patent:
**27.12.91 Bulletin 91/52**

(84) Designated Contracting States:
**BE DE FR GB SE**

(56) References cited:
**EP-A- 0 107 508**
**FR-A- 2 511 042**
**FR-A- 2 512 838**
**US-A- 4 013 424**
**US-A- 4 459 160**

(73) Proprietor: **UNITED TECHNOLOGIES CORPO-RATION**
**United Technologies Building 1, Financial Plaza**
**Hartford, CT 06101(US)**

(72) Inventor: **Hecht, Ralph J.**
**130 Bowsprit**
**North Palm Beach Florida 33408(US)**
Inventor: **Khan, Abdus S.**
**807 - 8th Terrace**
**Palm Beach Gardens Florida 33410(US)**
Inventor: **Barkalow, Richard H.**
**118 Linda Lane**
**Palm Beach Shores Florida 33404(US)**

(74) Representative: **Schmitz, Jean-Marie et al**
**OFFICE DENNEMEYER S.à.r.l. P.O. Box 1502**
**L-1015 Luxembourg(LU)**

## Description

The present invention concerns an oxidation resistant article and it relates to the field of protective overlay coatings for superalloy articles.

A primary problem which must be addressed in order to improve the performance and longevity of gas turbine engines is that of oxidation of the high temperature turbine components. The structural superalloy materials employed for gas turbine components have some degree of inherent oxidation resistance, however, the compositional compromises necessary to achieve the ultimate in mechanical properties generally result in the reduction of the materials' oxidation resistance to below that which is required for long-term use. In addition, the trend in gas turbine engines is always towards increasing temperatures to improve performance and efficiency. The oxidation rate of materials increases dramatically with increasing temperature.

For these reasons, for at least twenty years it has been customary to use protective coatings on gas turbine engine components. Such coatings are two general types, the aluminide type and the overlay type. Aluminide-type coatings are produced by diffusing aluminum into the surface of the component at elevated temperature in order to provide an aluminum rich surface zone which increases the material's oxidation resistance by providing sufficient aluminum to develop a protective alumina scale and providing sufficient aluminum to reform this scale as it spalls from the surface under use conditions. The aluminide-type coatings are generally quite thin and are life limited by the further diffusion of the aluminum into the component and by spallation of the aluminum oxide surface scale, both of which ultimately reduce the surface aluminum level to below the level which will form an alumina surface scale. However, such coatings are desirable for high performance engines inasmuch as the components coated with aluminide coatings are found to have substantially enhanced resistance to thermal fatigue when compared with overlay coated parts.

Overlay-type coatings consist of a discrete layer of an oxidation resistance alloy which is deposited on the surface of the component by means which include, for example, vapor deposition or plasma spraying. Overlay coatings are generally developed to be inherently oxidation resistant but they are developed in large measure without much consideration of the substrate to which they are to be applied. Thus, for example, a single overlay coating composition may be applied to many different composition substrates. Of course, such overlay coatings are optimized for oxidation resistance by more or less trial and error approach in which coated samples are tested and the coating then modified and retested. However, such trial and error techniques start from an arbitrary oxidation resistant material baseline rather than from the substrate composition.

It is an object of this invention to describe techniques which can be used to develop substrates specific protective coatings by starting with the substrate composition and modifying it to improve its oxidation resistance without significantly reducing its other important properties.

It is another object of this invention to describe coated articles in which the substrate composition is highly similar to the coating composition.

These objects and others which will become apparent hereinafter are accomplished by the present invention.

The oxidation resistant article of the present invention is defined as shown in claim 1.

Basically, a substrate composition is modified to arrive at the coating composition by increasing the aluminum contents somewhat, maintaining the chromium content at a level sufficient to guarantee the formation of an alumina surface layer, reducing the molybdenum and tungsten where present and substituting for them tantalum, and adding the elements yttrium, hafnium, and optionally silicon. The resultant coating has a microstructure which is similar to that of the substrate, in contrast to the microstructure of prior art overlay coatings which have had a variety of phases in the coating not found in the substrate.

The foregoing and other objects, features and advantages of the present invention will become more apparent from the following description of the best mode for carrying out the invention and the accompanying drawings.

Figure 1 is a photomicrograph showing a superalloy substrate having a conventional overlay coating before high temperature exposure;

Figure 2 shows the coated article of Figure 1 after a 100 hour exposure at 1150° C (2100° F); and

Figure 3 shows a superalloy substrate having a coating designed according to the present invention after a 100 hour exposure at 1150° C (2100° F).

According to the present invention, coatings can be designed which are effective in protecting substrates and which are based on and derived from the substrate composition.

The microstructure of superalloys of commercial interest consists essentially of a gamma (nickel solid solution) matrix containing strengthening gamma prime precipitates (based on the phase $Ni_3Al$). A broad composition range which encompasses such commercial alloys is presented below in Table I.

TABLE I

| (Wt. Percent) | |
|---|---|
| Al | 3-7 |
| Ti | 0.5-5 |
| Cr | 5-18 |
| Co | 0-20 |
| Mo | 0-7 |
| W | 0-14 |
| Ta | 0-14 |
| Nb | 0-4 |
| V | 0-2 |
| Re | 0-4 |
| Hf | 0-0.1 |
| Y | 0-0.2 |
| C | 0-0.2 |
| B | 0-0.02 |
| Zr | 0-0.5 |
| Ni | bal |

Of course, Table I covers many superalloy compositions and those skilled in the art will be able to determine those compositions which are of particular utility for their applications.

The coating which will be found to provide highly useful protection for such a substrate will microstructurally consist of at least 90 volume percent of the gamma and gamma prime phases and contain less than 10% by the volume of other phases such as the beta (NiAl) phase. This substantial microstructural similarity between the substrate and the coating goes a long way toward rendering the mechanical properties of the coating similar to the mechanical properties of the substrate, thereby reducing thermomechanically induced damage during service. It is preferred that the volume fraction of the gamma prime phase in the coating be similar to that of the substrate, although the aspects of the coating composition which will be subsequently described which involves increasing the the aluminum content will generally result in the coating having a gamma prime volume fraction which is somewhat greater than that of the substrate.

The desired coating composition is arrived at from the substrate composition by increasing the aluminum content sufficiently to insure that the oxide layer or scale which results in service, is alumina. In practice it will be found that aluminum content of from 7.5 to 11 wt.% in the coating will provide this desired result. Less aluminum may not produce alumina scales, more aluminum will result in the formation of undesirable extraneous phases in the microstructure. Those skilled in the art know quite well that the nature of the oxide layer is determined not only by the aluminum content but also by the chromium content and for this reason it is preferred that the coating contain from 9 to 16 wt.% chromium.

Commercial structural superalloys are strengthened not only by the gamma prime phase but by additions of refractory metals which include tantalum, tungsten, molybdenum, rhenium and miobium. It is desirable that the coating be as similar as possible to the substrate composition but a variety of effects interfere with this goal. In particular, molybdenum and tungsten have both been found to have deleterious effects on the oxidation performance of superalloys. Consequently, even though some alloys may contain as much as 10 or 12 wt.% of these elements, it is desirable that in the coating composition they be limited to a maximum of 4 wt.% each, and preferably a maximum of 3 wt.% each. Reducing these elements in the coating composition will reduce its strength and thereby render it perhaps more susceptible to various coating performance problems which are related to mechanical properties. For this reason, the molybdenum and tungsten can be replaced in whole or in part by tantalum which is found to have a beneficial effect on oxidation performance and will also provide a substantial strengthening effect. The tantalum content in this coating composition will range from 2 to 8 wt.%. When the molybdenum and tungsten levels are reduced it is desirable that the tantalum substitution be performed on an essentially equiatomic basis. Tantalum and tungsten (and also rhenium) have atomic weights of about 180 while molybdenum and miobium have atomic weights of 90. In order to compare the atomic percentages of the various refractory constituents, one

3

can multiply the tantalum, tungsten and rhenium contents by half. Thus, for example, a substrate containing 3 wt.% tantalum, 9 wt.% tungsten, 1 wt.% molybdenum would have its tantalum and tungsten content multiplied by one half and its molybdenum content multiplied by one in order to arrive at a comparative number 7 and this number could then be compared with that of a coating containing 6 wt.% tantalum which would have an effective number of 3. Thus, the coating in this case would have 43% of the atomic percentage of refractory metals when compared with the substrate. It is preferred that, on an atomic basis, the coating contain at least 30% of the refractory composition of the substrate and preferably at least 40%.

The refractory metals include tantalum, tungsten, molybdenum, rhenium and miobium and the previously mentioned number of 30% and preferably 40% should be applied to the total of the tantalum, tungsten, molybdenum, rhenium and miobium in the substrate and in the coating. Since only tungsten and molybdenum are known to be detrimental to oxidation resistance it is possible to substitute for some tungsten and molybdenum by increasing the rhenium and miobium levels as well as the previously mentioned increase in tantalum, but increasing the tantalum level is the preferred approach.

Other major elements found in commercial superalloys are titanium and cobalt. Titanium has been occasionally observed to have a somewhat detrimental effect on oxidation resistance and it is therefore preferred that the titanium content in the coating be reduced relative to that in the substrate; in most cases complete elimination of titanium will be found to be most desirable. Preferably, the titanium content in the coating should be less than 50% of that in the substrate. On the other hand, cobalt basically has very little effect on the oxidation performance of the coating material and consequently it may be present in an amount up to 125% of that of the substrate composition meaning that if the substrate contains 10 wt.% cobalt the coating could contain anywhere from 0 to 12,5 wt.% cobalt according to the teachings of the present invention.

The commercial overlay coatings are generically referred to as MCrAlY coatings in which M may be nickel, cobalt or iron and mixtures of nickel and cobalt, Cr is chromium, Co is cobalt, and Y is yttrium. Yttrium is present in amounts on the order of 1/2 to 1 wt.% but has a powerful effect on the oxidation resistance of the material. In some fashion, the yttrium acts to render the oxide scale which forms on the coating material very adherent to the coating material thereby substantially reducing spallation. A variety of elements, sometimes referred to as oxygen active elements, have been proposed to replace or supplement the yttrium content. These include lanthanum and cerium for replacement of yttrium and hafnium and silicon to supplement the yttrium. Other patents which relate to the concept of oxygen active elements in overlay coatings include US-A-4,419,416; 4,086,391 and 4,034,142.

Such oxygen active elements are essential to the success of the present invention and - yttrium is added in amounts of from 0.01 to 0.8% by weight, hafnium is added in amounts of 0.01 to .5% by weight, zirconium may be added in amounts of up to .5% by weight, and silicon may be added in an amount of up to 2% by weight. The yttrium and hafnium act to improve the adherence of the oxide layer while the silicon apparently acts by modifying the oxide layer so as to render it more resistant to the diffusion of oxygen.

There are several other minor elements which are commonly added to superalloy articles, particularly the polycrystalline superalloy articles. These elements are carbon, boron and occasionally vanadium. Carbon and boron (as well as zirconium) are commonly added to polycrystalline superalloy articles for the purposes of enhancing grain boundary ductility. These elements apparently have a somewhat detrimental effect on oxidation resistance and they are generally not favored for addition to coatings according to the present invention. Vanadium is added to certain superalloys for the purposes of improving mechanical properties such as tensile strength and since it has been found to have an adverse effect on oxidation, no intentional additions of vanadium are made to the present invention.

A primary benefit of the present invention which has not been fully discussed heretofore is the improvement in diffusional stability exhibited by the invention. Those skilled in the metallurgy art appreciate that when different compositions of materials are joined together and then heated to elevated temperatures, diffusion occurs between the two articles. The driving force for such diffusion is the difference in composition. In the case of overlay coatings, where the inherent oxidation resistance of the coating is the result of the alumina layer scale which forms in service, the coating can degrade from two basic mechanisms. The first is the perhaps obvious external mechanism of scale spallation. Since the scale is based on $Al_2O_3$, every time the scale spalls, a certain quantity of aluminum is lost from the surface layer. Eventually, through this mechanism, the aluminum content of the surface composition of the coated article will drop below that necessary to produce an aluminum oxide layer. When this happens, other complex compounds such as spinels form and subsequent oxidation is extremely rapid, if not catastrophic.

The internal coating degradation mechanism involves diffusion of materials either from the substrate into the coating or from the coating into the substrate. In the first instance, for example, molybdenum and/or tungsten in the underlying substrate can diffuse into the surface of the coating and thereby interfere with the formation of protective scales. In the latter instance, an essential element from the coating such as chromium or aluminum, can diffuse into the substrate thereby eventually depleting the surface layer of chromium and/or aluminum so that the scale which forms on the outer surface of the coated article is no longer alumina. It is this latter internal mechanism which is addressed by tailoring the substrate and coating compositions to each other.

The depth of interdiffusion between the coating and the substrate can be evaluated by optical microstructural evaluation. This is done by observing what is referred to as the diffusion zone between the substrate and the coating and this zone is delineated by a change in the phases present.

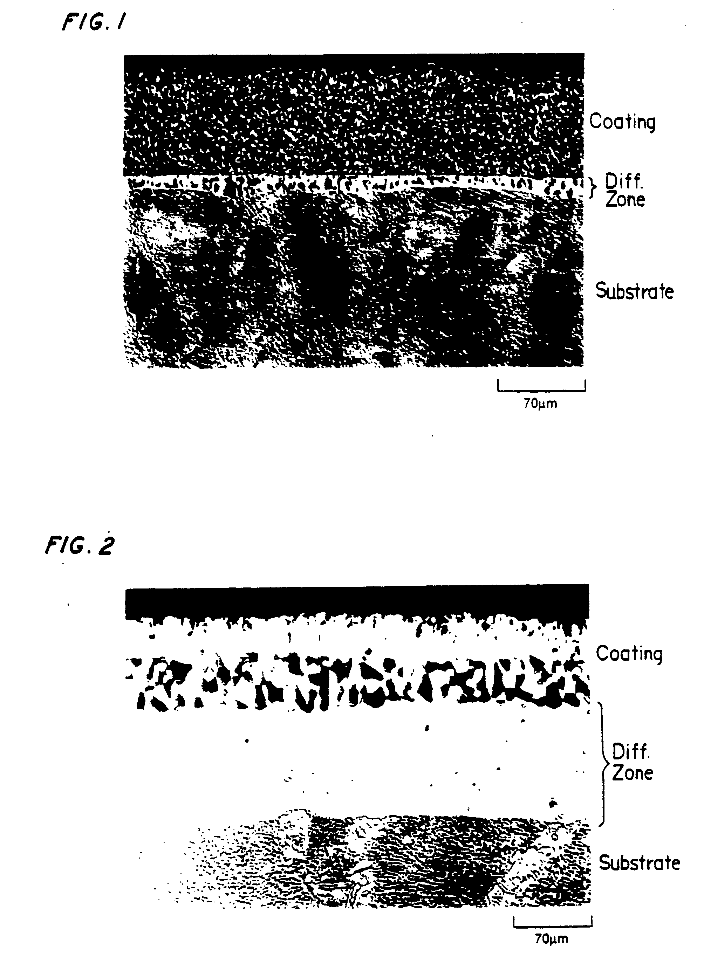

Figure 1 shows an optical photomicrograph of as-processed superalloy substrate having thereon an MCrAlY coating. The substrate and coating compositions are presented in Table II. A slight interdiffusion zone (approximately 15 μm) can be seen, the result of coating-substrate interaction during the elevated temperature deposition process and a 1080°C (1975°F)/4 hour heat treatment which is a conventional heat treatment used to improve the adherence of the coating to the substrate.

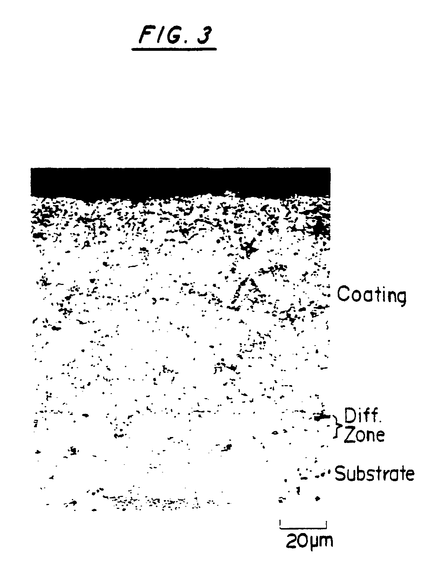

Figure 2 shows the appearance of the coated substrate after 100 hours of exposure at 1150°C (2100°F). The width of the interdiffusion zone is seen to be greater than that of the remaining coating structure (approximately 90 μm). This can be contrasted with Figure 3 of an invention substrate/coating combination after 100 hours at 1150°C (2100°F). (The compositions are given in Table II). A slight (approximately 10 μm) can be seen. Note the reduction in diffusion zone thickness from approximately 90 μm (microns) in the prior art case to about 10 μm (microns) in the invention case, showing a significant improvement.

Thus, it can be seen that the coating illustrated in Figure 3 which was based on the substrate composition was substantially more diffusion resistant than the arbitrarily developed prior art composition shown in Figures 1 and 2.

TABLE II

|  | Figures 1 & 2 (Prior Art) | | Figure 3 (Invention) | |
|  | Substrate (Wt.%) | Coating (Wt.%) | Substrate (Wt.%) | Coating (Wt.%) |
| --- | --- | --- | --- | --- |
| Cr | 9 | 18 | 9 | 9.2 |
| Co | 10 | 23 | 5 | -- |
| W | 12 | -- | 9 | -- |
| Nb | 1 | -- | -- | -- |
| Ta | -- | -- | 3 | 6.3 |
| Mo | -- | -- | 1 | -- |
| Ti | 2 | -- | 1.5 | -- |
| Al | 5 | 12.5 | 7 | 9.8 |
| B | 0.015 | -- | -- | -- |
| Hf | 2 | -- | -- | 0.27 |
| Y | -- | .3 | -- | 0.21 |
| Ni | Bal | Bal | Bal | Bal |

Because of the similarity of the coating and substrate compositions, the mechanical properties are also well matched. Thus, for example, in a thermal fatigue test in which the onset of coating failure in a conventional overlay coated substrate is observed after 6000 cycles, a variety of substrate tailored coatings developed according to the present invention does not show signs of failure until experiencing between 7000 and 11,000 cycles.

In terms of oxidation resistance, the previously mentioned diffusion tests are a good predictor of oxidation resistance; the negligible diffusion zone shown in Figure 3 indicates that the alloy remains able to form the necessary protective alumina scale. In fact, whereas a conventional overlay coating when tested at 1150°C (2100°F) has a life of about 300 hours, the coating according to the present invention was tested for over 800 hours at a higher temperature of 1205°C (2200°F) without displaying any signs of incipient failure.

**Claims**

1. An oxidation resistant article which comprises:

5

a superalloy substrate, having a microstructure which consists of a gamma phase matrix containing gamma prime precipitates, consisting of (by wt.) 3-7% Al, 0.5-5% Ti, 5-18% Cr, 0-20% Co, 0-7% Mo, 0-14% W, 0-10% Ta, 0-4% Nb, 0-2% V, 0-4% Re, 0-0.1% Hf, 0-0.2% Y, 0-0.2% C, 0-0.02% B, 0-0.2% Zr, balance Ni;

a coating on said substrate, said coating being derived from and being compositionally similar to said substrate, said coating having a microstructure which contains at least 90% by volume of the gamma and gamma prime phases, consisting of (by wt.) 7.5-11% Al, 9-16% Cr, 2-8% Ta, (said tantalum being added as an equiatomic replacement for at least some of said W and Mo when these elements are present in quantities of more than 4 in the substrate, less than 4% Mo, less than 4% W, 0-3% Re, 0-4% Nb, with the atomic percent of Ta + w + Mo + Re + Nb of the coating being at least 30% of the atomic percent of the Ta + W + Mo + Re + Nb in the substrate, 0.01-0.8% Y, 0.1-0.5% Hf, 0-2% Si, with no intentional additions of V, C, B or Zr, and containing Ti, in an amount less than the Ti content of the substrate composition, and the element Co in an amount up to 125% of the substrate composition, balance Ni;

said coating developing a stable alumina scale upon exposure to elevated temperature oxidizing conditions, and said coating and said substrate being diffusionally stable and having similar coefficients of thermal expansion so that said coated article is adapted to resist oxidation and thermal fatigue for extended periods.

2. An article as in claim 1 in which the Mo and W levels in the coating are each less than 3% by weight.

3. An article as in claim 1 in which all of the elements in the coating (except for Hf, Y, Si) are present in the substrate.

4. An article as in claim 1 in which the Ti content is less than 50% of the substrate Ti content.

**Revendications**

1. Article résistant à l'oxydation comprenant :

un substrat en superalliage dont la microstructure comprend une matrice de phase gamma contenant des précipités de phase gamma prime, constitué par (en poids) 3-7% Al, 0,5-5% Ti, 5-18% Cr, 0-20% Co, 0-7% Mo, 0-14% W, 0-10% Ta, 0-4% Nb, 0-2% V, 0-4% Re, 0-0,1% Hf, 0-0,2% Y, 0-0,2% C, 0-0,02% B, 0,02% Zr, le reste étant Ni ;

un recouvrement sur ce substrat, ce recouvrement dérivant du substrat et étant, quant à sa composition, semblable à ce dernier, le recouvrement comprenant une microstructure qui contient au moins 90% en volume des phases gamma et gamma prime, constituées par (en poids) 7,5-11% Al, 9-16% Cr, 2-8% Ta (le tantale étant ajouté à titre de remplacement équiatomique pour au moins une partie de W et de Mo, lorsque ces éléments sont présents dans des quantités supérieures à 4 dans le substrat), moins de 4% Mo, moins de 4% W, 0-3% Re, 0-4% Nb, le pourcentage atomique de Ta + W + Mo + Re + Nb du recouvrement représentant au moins 30% du pourcentage atomique de Ta + W + Mo + Re + Nb dans le substrat, 0,01-0,8% Y, 0,1-0,5% Hf, 0-2% Si, sans addition intentionnelle de Y, C, B ou Zr, et contenant Ti en une quantité inférieure à la teneur en Ti de la composition du substrat, ainsi que l'élément Co en une quantité allant jusqu'à 125% de la composition du substrat, le reste étant Ni ;

ce recouvrement formant une écaille stable en alumine lorsqu'on l'expose à des conditions d'exposition à des températures élevées, le recouvrement et le substrat étant stables quant à la diffusion et présentant des coefficients semblables de dilatation thermique, de telle sorte que l'article recouvert est conçu pour résister à l'oxydation et à la fatigue thermique pendant des laps de temps prolongés.

2. Article selon la revendication 1, dans lequel les teneurs en Mo et W dans le recouvrement sont chacune inférieures à 3% en poids.

3. Article selon la revendication 1, dans lequel tous les éléments présents dans le recouvrement (à l'exception de Hf, Y, Si) sont présents dans le substrat.

4. Article selon la revendication 1, dans lequel la teneur en Ti est inférieure à 50% de la teneur du substrat en Ti.

**Patentansprüche**

1. Oxidationsbeständiger Gegenstand, mit:
einem Superlegierungssubstrat, das ein Mikrogefüge hat, welches aus einer γ-Matrix besteht, die γ'-Abscheidungen enthält und (gewichtsmäßig) aus 3-7% Al, 0,5-5% Ti, 5-18% Cr, 0-20% Co, 0-7% Mo, 0-14% W, 0-10% Ta, 0-4% Nb, 0-2% V, 0-4% Re, 0-0,1% Hf, 0-0,2% Y, 0-0,2% C, 0-0,02% B, 0-0,2% Zr, Rest Ni, besteht;
einem Überzug auf dem Substrat, der von dem Substrat abgeleitet wird und diesem zusammensetzungsmäßig gleicht, wobei der Überzug ein Mikrogefüge hat, das wenigstens 90 Vol.% der γ- und γ'-Phasen enthält, und aus (gewichtsmäßig) 7,5-11% Al, 9-16% Cr, 2-8% Ta (wobei das Tantal als ein gleichatomiger Ersatz für wenigstens etwas von dem W und Mo zugesetzt wird, wenn diese Elemente in Mengen von mehr als 4 in dem Substrat vorhanden sind), weniger als 4% Mo, weniger als 4% W, 0-3% Re, 0-4% Nb, wobei die Atomprozentsatz von Ta + W + Mo + Re + Nb des Überzugs wenigstens 30% des Atomprozentsatzes von Ta + W + Mo + Re + Nb in dem Substrat ausmacht, 0,01-0,8% Y, 0,1-0,5% Hf, 0-2% Si, ohne absichtliche Zusätze von V, C, B oder Zr und enthaltend Ti in einer Menge von weniger als dem Ti-Gehalt der Substratzusammensetzung, und dem Element Co in einer Menge bis zu 125% der Substratzusammensetzung, Rest Ni, besteht;
wobei der Überzug einen stabilen Aluminiumoxidzunder bildet, wenn er bei erhöhter Temperatur oxidierenden Bedingungen ausgesetzt wird, und wobei der Überzug und das Substrat diffusionsmäßig stabil sind und ähnliche Wärmeausdehnungskoeffizienten haben, so daß der überzogene Gegenstand in der Lage ist, sich Oxidation und thermischer Ermüdung für lange Zeitspannen zu widersetzen.

2. Gegenstand nach Anspruch 1, bei dem die Mo- und W-Gehalte in dem Überzug jeweils weniger als 3 Gew.% betragen.

3. Gegenstand nach Anspruch 1, bei dem alle Elemente in dem Überzug (mit Ausnahme von Hf, Y, Si) in dem Substrat vorhanden sind.

4. Gegenstand nach Anspruch 1, bei dem der Ti-Gehalt weniger als 50% des Substrat-Ti-Gehalts beträgt.

*FIG. 1*

Coating

} Diff. Zone

Substrate

70μm

*FIG. 2*

Coating

} Diff. Zone

Substrate

70μm

## FIG. 3

Coating

Diff.
Zone

Substrate

20µm